Europäisches Patentamt

(19) European Patent Office

Office européen des brevets

(11) Publication number: **0 174 877**
**B1**

(12) **EUROPEAN PATENT SPECIFICATION**

(45) Date of publication of the patent specification:
**02.08.89**

(21) Application number: **85307889.7**

(22) Date of filing: **31.10.85**

(51) Int. Cl.⁴: **H01J 35/00, G03F 7/20,**
**H01J 5/18**

(54) X-ray application system.

(30) Priority: **08.11.84 US 669442**

(43) Date of publication of application:
**19.03.86 Bulletin 86/12**

(45) Publication of the grant of the patent:
**02.08.89 Bulletin 89/31**

(84) Designated Contracting States:
**AT BE CH DE FR GB IT LI LU NL SE**

(56) References cited:
**WO-A-79/00340**
**WO-A-83/03674**
**US-A- 3 562 793**
**US-A- 4 121 128**
**US-A- 4 184 078**
**US-A- 4 304 627**

(73) Proprietor: **HAMPSHIRE INSTRUMENTS, INC, 10,**
**Carlson Road, Monroe New York(US)**

(72) Inventor: **Forsyth, James Morton, 54 Old Forge Lane,**
**Pittsford New York 14534(US)**

(74) Representative: **Miller, Joseph et al, J. MILLER & CO.**
**Lincoln House 296-302 High Holborn, London**
**WC1V 7JH(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

ACTORUM AG

## Description

This invention relates to X-ray application systems, and particularly, but not exclusively, to X-ray lithography machines in which soft X-rays are generated from a plasma created by focussing a high powered laser beam on a suitable target.

Conventional integrated circuit chips are fabricated by a technique known as photolithography. In a photolithography system, for example, as disclosed in US-A-4,444,492, ultraviolet light of a certain wavelength is applied through a mask to a semiconductor wafer coated with a compound known as photoresist. The mask serves to block the light from reaching certain portions of the photoresist while allowing the light to reach other portions. The portion in which the light is applied to the photoresist results in the photoresist becoming exposed. By known techniques, either the exposed or the unexposed photoresist can be removed, leaving a pattern on the semiconductor wafer after removal of the exposed photoresist. Thereafter, the exposed semiconductor material can be implanted with doping materials to form P or N regions, or oxide or metal layers may be applied in known manners. The technique of applying the light through the mask to the semiconductor wafer occurs generally for each major step in the process of fabricating the semiconductor device.

It is a well known limitation of photolithography that the resolution and size of the lines which can be fabricated on the semiconductor wafer are limited by the wavelength of the light used. Present modern photolithography techniques generally limit the width of a line to approximately 0.0254 mm (one micron) due to the wavelength of the light used in the photolithography process. However, as chips become more dense, it is desirable that the width of the lines on a chip be smaller than the practical limit of 0.0254 mm (one micron) achievable with photolithography techniques.

One suggested manner of reducing the width of the lines is to use X-rays rather than light as the exposing radiation, because X-rays have a smaller wavelength than light. For example, it has been proposed in US-A-3,743,842 to use soft X-rays (wavelength 0.2 to 2 mm) which are applied through an X-ray mask to expose an X-ray resist material on a semiconductor device. The soft X-rays are generated by impinging an electron beam on a target. However it has been found that the X-ray generating means proposed in US-A-3,743,842 provides insufficient X-rays and thus require 10 or more minutes to expose the X-ray resist. Because of this, it is difficult to use the proposed method to expose the X-ray resist material in production, Where the exposure time should be measured in tenths of seconds or less.

One technique to overcome the above noted problems with respect to X-ray lithography systems is described in US.-A-4,184,078 which discloses a system in which a soft X-ray emitting plasma is created by, for instance, focussing a high powered laser pulse on a target material, such as aluminium, thereby creating a plasma at the point at which the laser beam strikes the target. The plasma, in turn, emits soft X-rays in a narrow band dependent upon the target material. If sufficient power from the laser pulse were present, sufficient X-rays could be generated to allow exposure in an extremely short time (e.g. nanoseconds).

As described in US-A-4,184,078, in order to create the necessary plasma to generate X-rays, the target must be placed within an evacuated chamber. For example, the pressure within the chamber holding the target should be less than 1.333224 Pa (0.01 Torr). As described in US-A-4,184,078, the mask and X-ray resist-coated semiconductor wafer are placed within the evacuated chamber so that the X-rays can expose them. The reason for this is that conventional vacuum chambers are constructed of a material which will absorb the X-rays. Hence the chamber itself will block the X-rays from reaching a mask and X-ray resist-coated wafer placed outside of the chamber.

Another recognised problem inherent in the design described in US-A-4,184,078 is that when the plasma is created by focussing the laser beam on the target a certain amount of debris is created. US-A-4,184,078 discloses the use of moving Mylar sheets over the mask in an attempt to block the debris. However, as the debris is scattered throughout the chamber, it eventually settles on the mask and leads to defects in the subsequent exposures due to the shadows cast by debris particles through the transparent openings in the mask.

Another problem common with the prior art techniques proposed in US-A-3,743,842 and US-A-4,184,078 is that the X-rays applied to the mask, particularly those X-rays absorbed by the areas of the mask designed to block the passage of X-rays, cause the mask temperature to increase. As the temperature of the mask increases, the mask tends to deform and may cause a misalignment or other distortion between the mask and previous exposed patterns fabricated on the semiconductor wafer. It would be more desirable to have the mask maintained at a constant temperature so that the pattern of X-rays hitting the X-ray resist-coated wafer is more accurately controllable.

The present application refers to an X-ray application system according to the preamble of Claim 1. Such a system is known from WO-A 8 303 674.

This invention is characterised in that the gas sheet is thin and flowing, and the thickness of the gas sheet being such as to stop the most energetic debris particles, the gas sheet in use, intercepting the debris emitted by the target and inhibiting it reaching the mask.

For example one aspect of the invention is an X-ray application system comprising a laser beam source for generating a laser beam, a target upon which the laser beam is focussed, the laser beam being of sufficient intensity to create a plasma from the target material, there being soft X-rays and debris emitted from the plasma along a given path, an X-ray mask positioned to pass a pattern of X-rays to an object, and means to generate a curtain of an X-ray transparent gas across the path between the mask and the target to displace the debris away from the mask.

A further aspect of the invention is an X-ray lithography system comprising means for generating X-rays, a semi-conductor device positioned in the path of the X-rays, a mask positioned between the device and the X-ray generating means to allow a defined pattern of X-rays to strike the device, the device and the mask being aligned with respect to one another so that the pattern of X-rays is at a desired position on the device, and means for providing at least one curtain of X-ray transparent gas a given distance from the mask, the given distance being selected so that the gas curtain removes heat from the mask without affecting the alignment between the mask and device.

From a still further aspect the invention is related to an X-ray application system comprising an evacuated chamber having an opening, a target within the chamber, means to focus a laser beam on the target to create a plasma from which is emitted soft X-rays towards the opening, an object outside the chamber to be irradiated by the X-rays, and means for providing an X-ray transparent gas curtain across the opening to maintain a pressure differential between the inside and the outside of the chamber.

Further aspects of the invention will be found in the dependent claims.

The scope of the invention is defined by the appended claims; and how it can be carried into effect is hereinafter particularly described with reference to the accompanying drawings, in which:-

Figure 1 shows diagrammatically one embodiment of an X-ray lithography system according to the invention,

Figure 2 is a scrap view of Figure 1, showing the manner in which the plasma and debris are formed,

Figure 3 is a view in the direction of the arrows 3-3 of Figure 1,

Figure 4 shows diagrammatically an alternative embodiment of the invention, and

Figure 5 shows diagrammatically a third embodiment of the invention.

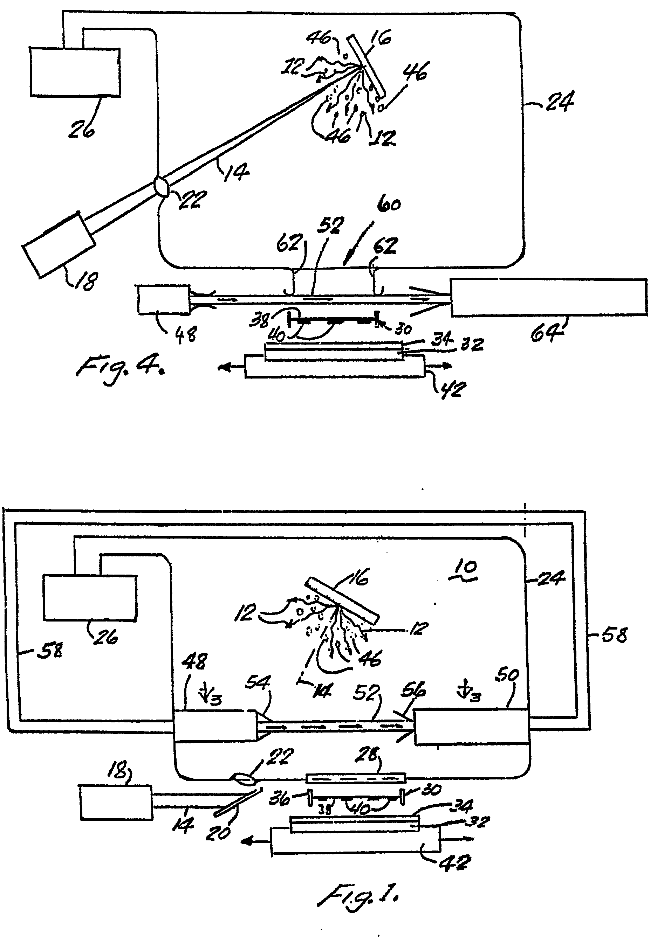

An X-ray lithography system 10 (Figure 1) according to the invention, includes a target 16 upon which is focussed a laser beam 14 to generate X-rays 12. The target 16 may be any material from which an X-ray generating plasma is generated when struck by the laser beam 14, for example, a metal, such as iron, which causes X-rays of a wavelength of 08-1.5 mm to be generated. The laser beam 14 is generated by a laser generator 18 providing a high powered laser pulse, containing for example, 10 joules of energy and having a duration in the 1 to 10 ns range. The laser beam 14 is directed at a mirror 20 which reflects the beam 14 through a lens 22 which focusses the beam 14 at a particular spot on the target 16, having, for example, a diameter of approximately 1.016 to 2.032 mm (40 to 80 microns) at the surface of target 16. In order that plasma be created when the laser beam 14 is focussed on the target 16, it is necessary that the target 16 be within an evacuated chamber 24, the pressure in which is maintained low relative to that outside by a vacuum pump 26. For example the pressure within chamber 24 may be less than 13.33224 Pa (0.1 Torr).

At least some of the X-rays 12 generated from target 16 pass through an X-ray transparent window 28 in the bottom of the chamber 24. The window 28 may be any material transparent to X-rays, such as heavy gauge beryllium foil which is of sufficient strength to withstand the pressure differential on both sides thereof. The lens 22 is also in the wall of chamber 24, so that the laser generator 18 and mirror 20 may be outside the chamber 24.

The X-rays passing through the window 28 are directed towards an object, such as a mask 30 and semiconductor wafer 32. The mask 30 is a known device which will selectively pass X-rays to form a pattern on the semiconductor wafer 32 which is coated with a layer of X-ray resist material 34 which becomes exposed by the X-rays. The mask 30 includes an X-ray transparent membrane 38 mounted in a frame 36. Affixed to membrane 38 is a pattern of X-ray absorbing material 40, such as gold, which blocks the X-rays from being applied to expose X-ray resist material 34. Exposed X-ray resist material 34 may be further processed in known manner to form a semi-conductor integrated circuit.

The mask 30 is held in a fixed position and the semiconductor wafer 32 is moved between various positions so that each individual area thereof may be exposed by X-rays passing through the mask 30. The wafer 32 is held by a wafer handling device 42 which is controlled to cause the wafer to move between the various areas desired for exposure. Such a wafer handling device is described in US-A 4,444,492.

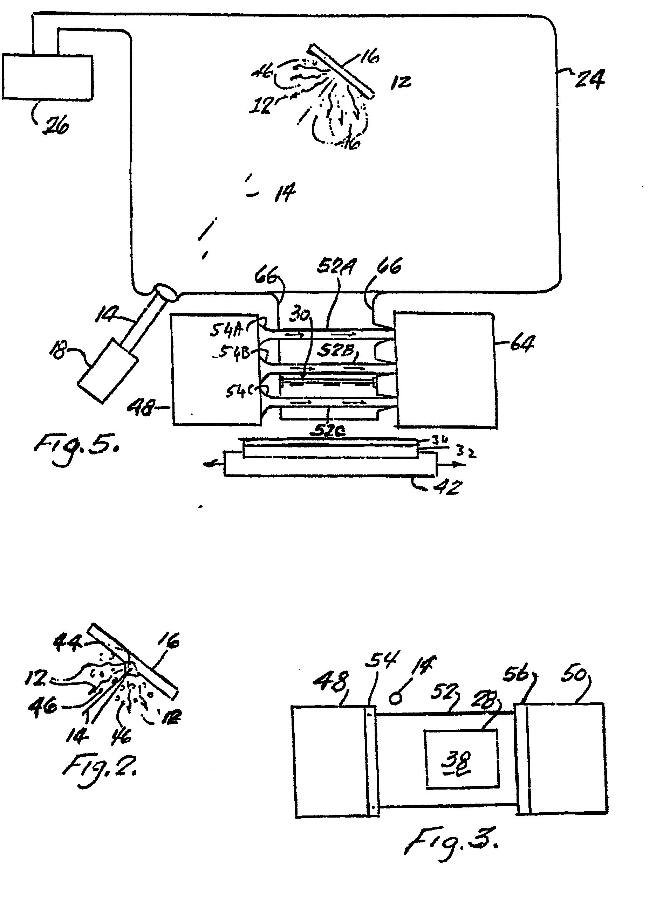

When the laser beam 14 strikes the target 16, a certain portion of target 16 is burnt away as the temperature is raised to over one million degrees Celsius. This, in turn, causes an area of plasma 44 (Figure 2) to be formed and X-rays 12 are emitted from the plasma. In addition to the X-rays 12, minute particles 46 of debris are emitted as the plasma cools.

These particles 46 fall upon window 28 (Figure 1) and act as X-ray absorbing matter partially to block the passage of X-rays through the window 28 towards the mask 30. If the mask 30 were placed within the chamber 24, as disclosed in US-A-4,184,078, the particles of debris 46 would fall directly on the mask 30, thereby causing damage due to the heat of the particles as well as blocking the pattern of X-rays provided by the mask 30.

Within the chamber 24, a gas compressor 48 provides a thin jet stream of gas to form a sheet or curtain 52 of gas through a nozzle 54 to a funnel 56 which accepts the gas and directs it into a collector/separator 50. The compressor 48 and collector/separator 50 are spaced and located below the target 16 and above the window 28, so that the curtain 52 of gas is at least as wide as the window 28 (Figure 3) through which is seen the membrane 38 of mask 30.

As the particles 46 of debris fall from the target 16 towards the window 28, they are swept away by gas curtain 52. The collector/separator 50 separates the particles from the gas and directs the gas through a return path 58 to the input of the compressor 48. It is important that the type of gas selected to be formed into the gas curtain 52 be a substantially X-ray transparent gas. Low molecular weight gases, such as air, hydrogen, helium and nitrogen are sufficiently X-ray transparent to ensure that X-rays are not absorbed into the gas, but rather pass on through the gas curtain 52 and window 28 to the mask 30. The thickness of gas curtain 52 should be chosen to stop the most energetic debris particles. All the gas should be collected into collector/separator 50 in order to prevent loss of partial vacuum within the chamber 24.

The design of the nozzle 54 will produce a laminar flow condition in the gas curtain 52. This laminar flow gas curtain would tend to carry debris particles throughout the gas handling system or out of the exhaust, if so fitted. To separate debris from the gas curtain, the collector/separator 50 is used, and includes a diffuser to break up the gas flow lines into a turbulent structure, causing the debris to fall into a collector located below the diffuser.

In an alternative embodiment of the present invention (Figure 4), certain components are positioned differently. The mirror 20 is eliminated and the laser beam 14 is directed at the lens 22 by the laser generator 18. The lens 22 is also positioned in the side wall of the chamber 24 rather than in the bottom. The closed window 28 is replaced by an open window 60 defined by flanges 62 extending from the bottom of the chamber 24.

The curtain 52 of gas is directed by compressor 48 across the flanges 62 of open window 60. The curtain of gas 52 serves the function of maintaining the vacuum within the chamber 24 created by the pump 26, as well as blowing away any debris particles 46 that fall from the target 16 through the open window 60. Thus, the curtain of gas 52 serves the dual function of maintaining the vacuum within chamber 24 and dispersing the debris particles 46.

By placing the mask 30 sufficiently close to sheet 52, the heat generated within the mask 30 by the absorption therein of X-rays 12 can also be dissipated. Care must be taken, however, that the mask 30 is not so close to gas curtain 52 that the turbulence effects created at the outer boundary of gas curtain 52 physically affect the mask 30 or the alignment of the mask 30 with respect to wafer 32. Thus, the gas curtain 52 may perform three separate functions in maintaining vacuum in the chamber 24 with an open window blowing away debris particles 46 and cooling the mask 30.

The collector/separator 50 is replaced by a collector, separator, diffuser and exhaust system 64. This system is used because the gas is not fed back to the compressor 48, but is exhausted into the surrounding atmosphere. It is preferred to use the collector/separator 50 with a feed back return path 58 to the compressor 40 in place of the system 64, where a gas other than air is used.

In a third embodiment of the invention (Figure 5) the window 28 or flanged opening 60 is replaced by a neck 66 at the bottom of chamber 24. The neck 66 is in the form of extended flanges around an opening and the compressor 48 has three nozzles 54A, 54B, 54C providing spaced gas curtains 52A, 52B and 52C through one wall of the neck 66. The curtains 52A, 52B and 52C are directed to funnels 56A, 56B and 56C, respectively, in the opposite wall of the neck 66, and the funnels guide the gas into a collector, separator, diffuser and exhaust system 64. Thus the compressor 48 provides three separate gas curtains 52A, 52B and 52C within the neck 66 to maintain a greater pressure differential on both sides of the chamber 24 than the single gas curtain would maintain. The nozzles and funnels may be formed within the neck 66 or may be a part of the compressor 48 and collector, separator, diffuser and exhaust system 64.

In the embodiment of Figure 5, the mask 30 is placed within the neck 66 between two of the gas curtains 52B and 52C, both of which cool the mask 30. Again care must be taken to avoid any turbulence effect of mask 30 on the gas curtains 52B or 52C. Thus the gas curtains 52A, 52B and 52C in Figure 5 perform the same three functions as the gas curtain 52 in Figure 4, that is they disperse the debris particles 46 formed from target 16, they maintain the vacuum within chamber 24 so that an opening may be used which does not absorb X-rays and they cool mask 30 so that it may be maintained at a constant temperature.

The same cooling effect provided by the two gas curtains 52B and 52C in the Figure 4 embodiment between mask 30 and the semiconductor wafer 32. This may be preferable for certain materials used in mask 30 where insufficient heat escapes due to the partial vacuum between gas curtains 52B and 52C in Figure 5.

**Claims**

1. An X-ray application system comprising a source of X-rays within an evacuated chamber (24), the source of X-rays including a target (16) in which, in use, an X-ray and debris emitting plasma is generated, a mask (30) toward which X-rays are directed to provide a predefined image of X-rays beyond the mask (30), and means (48, 54, 56, 50) for providing a sheet (52) of X-ray transparent gas between the target (16) and the mask (30), characterised in that the gas sheet (52) being such as top the most energetic debris particles, the gas sheet (52) in use, intercepting the debris by the target and inhibiting it reaching the mask (30).

2. A system according to claim 1, in which the plasma is generated, in use, by a laser beam (14) focussed on the target (16).

3. A system according to claim 1 or 2, in which the chamber (24) includes an opening (60) through which X-rays pass, the gas sheet (52) being directed across the opening to maintain a pressure differential across the opening.

4. A system according to claim 1, 2 or 3, in which the gas sheet (52) is directed near the mask (30) to cool the mask.

5. A system according to any preceding claim, in which there is a body (32) of semiconductor material and the mask is positioned between the semiconductor material and the gas sheet (52).

6. A system according to claim 2, or any claim appendant to claim 2, in which the laser beam (14) is of sufficient intensity to create a plasma from the material of the target (16) upon which the laser beam is focussed, soft X-rays (12) and debris being emitted from the plasma along a given path, and the gas sheet (52) displaces debris from that path away from the mask.

7. A system according to claim 6, in which the sheet of gas is generated by a compressor (48) and a sheet forming nozzle (54).

8. A system according to claim 6 or 7, in which the sheet of gas is directed to means (50, 64) to separate the debris from the gas.

9. A system according to claim 8, in which the separation means (64) includes means to diffuse and exhaust the gas.

10. A system according to claim 8, in which the separation means (50) directs gas, after separation, through a return path (58) to the gas sheet generator means (48).

11. A system according to claim 10, in which the gas is a low molecular weight gas.

12. A system according to claim 11, in which the gas is air, helium, nitrogen or hydrogen.

13. A system according to claim 6, or any claim appendant to claim 6, in which the means to generate the gas sheet is entirely within the chamber (24).

14. A system according to claim 13, in which the sheet (52) of gas is remote from the target (16).

15. A system according to claim 3, or any claim appendant to claim 3, in which an object to be irradiated by the X-rays is located outside the chamber (24).

16. A system according to claim 15, in which the mask is displaced from the sheet (52) of gas by a distance selected to minimise the movement of the mask (30), while at the same time to allow the gas sheet to cool the mask.

## Revendications

1. Système pour l'application de rayons X comprenant une source de rayons X dans une chambre à vide (24), la source de rayons X incluant une cible (16) dans laquelle, lors de l'utilisation, un plasma émettant des rayons X et des débris est généré, un masque (30) vers lequel sont dirigés des rayons X pour fournir une image pré-définie de rayons X derrière le masque (30), et des moyens (48, 54, 56, 50) pour générer un rideau (52) de gaz transparent aux rayons X entre la cible (16) et le masque (30), caractérisé en ce que le rideau de gaz (52) est mince et fluide, et a une épaisseur telle qu'il arrête les particules de débris les plus énergiques, ledit rideau de gaz (52), durant son utilisation, interceptant les débris émis par la cible et les empêchant d'atteindre le masque (30).

2. Système selon la revendication 1, caractérisé en ce qu'en utilisation, le plasma est généré par un rayon laser (14) dirigé sur la cible (16).

3. Système selon l'une des revendications 1 ou 2, caractérisé en ce que la chambre (24) présente une ouverture (60) à travers laquelle passent les rayons X, le rideau de gaz (52) étant dirigé à travers l'ouverture pour maintenir une différence de pression à travers l'ouverture.

4. Système selon l'une des revendications 1 à 3, caractérisé en ce que le rideau de gaz (52) est dirigé près du masque (30) pour le refroidir.

5. Système selon l'une des revendications précédentes, caractérisé en ce qu'il comporte un corps (32) en matériau semi-conducteur, le masque étant placé entre le matériau semi-conducteur et le rideau de gaz (52).

6. Système selon l'une des revendications 2, ou 3 à 5, caractérisé en ce que le rayon laser (14) a une intensité suffisante pour créer un plasma à partir du matériau de la cible (16) sur laquelle il est dirigé, des rayons X doux (12) et des débris étant émis par le plasma le long d'un trajet donné, et en ce que le rideau de gaz (52) disperse les débris dudit trajet pour qu'ils n'atteignent pas le masque.

7. Système selon la revendication 6, caractérisé en ce que le rideau de gaz est généré par un compresseur (48) et par une buse (54) capable de former un flux en forme de rideau.

8. Système selon l'une des revendications 6 ou 7, caractérisé en ce que le rideau de gaz est dirigé vers des moyens de séparation des débris du gaz (50, 64).

9. Système selon la revendication 8, caractérisé en ce que lesdits moyens de séparation (64) comprennent des moyens pour diffuser et évacuer les gaz.

10. Système selon la revendication 8, caractérisé en ce que lesdits moyens de séparation (50) dirigent le gaz, après séparation, par un trajet de retour (58), vers les moyens de génération de rideau de gaz (48).

11. Système selon la revendication 10, caractérisé en ce que le gaz est un gaz à faible poids moléculaire.

12. Système selon la revendication 11, caractérisé en ce que le gaz est de l'air, de l'hélium, de l'azote ou de l'hydrogène.

13. Système selon l'une des revendications 6 ou 7 à 12, caractérisé en ce que les moyens de génération du rideau de gaz sont entièrement compris à l'intérieur de la chambre (24).

14. Système selon la revendication 13, caractérisé en ce que le rideau de gaz (52) est éloigné de la cible (16).

15. Système selon l'une des revendications 3 ou 4 à 14, caractérisé en ce qu'un objet devant être irradié par les rayons X est situé à l'extérieur de la chambre (24).

16. Système selon la revendication 15, caractérisé en ce que le masque (30) est écarté du rideau de gaz (52) d'une distance choisie pour rendre minimum le mouvement du masque tout en permettant en même temps son refroidissement par le rideau de gaz.

## Patentansprüche

1. Vorrichtung zur Röntgenbestrahlung mit einer Röntgenstrahlenquelle innerhalb einer Vakuumkammer (24), wobei die Röntgenstrahlenquelle eine Fangelektrode (16) aufweist, in welcher während des Betriebes einen Röntgenstrahl und Überbleibsel abgebendes Plasma erzeugt wird, mit einer Maske (30), auf die Röntgenstrahlen gerichtet sind, um ein vorbestimmtes Bild von Röntgenstrahlen hinter der Maske (30) zu schaffen und Vorrichtungen (48, 54, 56, 50) zur Schaffung einer Schicht (52) eines röntgenstrahlendurchlässigen Gases zwischen der Fangelektrode (16) und der Maske (30), dadurch gekennzeichnet, daß die Gasschicht (52) flach und fließend ist und die Dicke der Gasschicht (52) derart ist, daß die meisten energetischen Überbleibselpartikel gestoppt werden, wobei die Gasschicht (52) während des Betriebes die Überbleibsel, die von der Fangelektrode abgegeben werden, abfängt und sie daran hindert bzw. sie verzögert, die Maske (30) zu erreichen.

2. Vorrichtung nach Anspruch 1, dadurch gekennzeichnet, daß das Plasma während des Betriebes durch einen Laserstrahl (14) erzeugt wird, der auf der Fangelektrode (16) fokussiert ist.

3. Vorrichtung nach Anspruch 1 oder 2, dadurch gekennzeichnet, daß die Kammer (24) eine Öffnung (60) aufweist, durch welche Röntgenstrahlen hindurchführen und die Gasschicht (52) sich über die Öffnung erstreckt, um ein Druckdifferenzial über der Öffnung aufrechtzuerhalten.

4. Vorrichtung nach Anspruch 1, 2 oder 3, dadurch gekennzeichnet, daß die Gasschicht (52) nahe der Maske (30) angeordnet ist, um die Maske zu kühlen.

5. Vorrichtung nach einem der vorhergehenden Ansprüche, dadurch gekennzeichnet, daß ein Körper (32) aus Halbleitermaterial vorgesehen ist und die Maske zwischen dem Halbleitermaterial und der Gasschicht (52) angeordnet ist.

6. Vorrichtung nach Anspruch 2 oder einem von Anspruch 2 abhängigen Anspruch, dadurch gekennzeichnet, daß der Laserstrahl (14) eine ausreichende Intensität aufweist, um ein Plasma vom Werkstoff der Fangelektrode (16) zu schaffen, auf welche der Laserstrahl fokussiert ist, wobei weiche Röntgenstrahlen (12) und Überbleibsel von dem Plasma längs eines vorbestimmten Weges abgegeben werden und die Gasschicht (52) von diesem Weg abgekommene Überbleibsel von der Maske abhält.

7. Vorrichtung nach Anspruch 6, dadurch gekennzeichnet, daß die Gasschicht durch einen Kompressor (48) und eine die Schicht formende Düse (54) erzeugt wird.

8. Vorrichtung nach Anspruch 6 oder 7, dadurch gekennzeichnet, daß die Gasschicht auf Vorrichtungen (50, 64) zu gerichtet ist, um die Überbleibsel von dem Gas zu trennen.

9. Vorrichtung nach Anspruch 8, dadurch gekennzeichnet, daß die Trennmittel (64) Vorrichtungen umfassen, um das Gas zu diffundieren und abzusaugen.

10. Vorrichtung nach Anspruch 8, dadurch gekennzeichnet, daß die Trennmittel (50) Gas nach der Abtrennung über einen Rückweg (58) zu dem Gasgenerator (48) zur Erzeugung der Gasschicht führen.

11. Vorrichtung nach Anspruch 10, dadurch gekennzeichnet, daß das Gas ein niedriges Molekulargewicht aufweist.

12. Vorrichtung nach Anspruch 11, dadurch gekennzeichnet, daß es sich bei dem Gas um Luft, Helium, Stickstoff oder Wasserstoff handelt.

13. Vorrichtung nach Anspruch 6 oder einem der vom Anspruch 6 abhängigen Ansprüche, dadurch gekennzeichnet, daß die Vorrichtungen zur Erzeugung der Gasschicht vollkommen innerhalb der Kammer (24) angeordnet sind.

14. Vorrichtung nach Anspruch 13, dadurch gekennzeichnet, daß die Gasschicht (52) von der Fangelektrode (16) entfernt ist.

15. Vorrichtung nach Anspruch 3 oder einem der von Anspruch 3 abhängigen Ansprüche, dadurch gekennzeichnet, daß ein von den Röntgenstrahlen zu bestrahlendes Objekt außerhalb der Kammer (24) angeordnet ist.

16. Vorrichtung nach Anspruch 15, dadurch gekennzeichnet, daß die Maske von der Gasschicht (52) in einer Entfernung angeordnet ist, die so ausgewählt ist, um die Bewegung der Maske zu minimieren, während gleichzeitig die Möglichkeit gegeben wird, daß die Gasschicht die Maske kühlt.

Fig. 4.

Fig. 1.

46 16

12 12

24

26

14

14

66 52A 66

18 54A 30

54B 52B 64

54C

48 52C

Fig.5. 34 32

42

44 16

12 46 12

14 46

Fig.2.

48 54 14 52 28 56 50

38

Fig.3.